# FASCICULE DE BREVET EUROPEEN

(11) **EP 3 520 132 B1**
(45) Date de publication et mention de la délivrance du brevet: **22.07.2020**
(21) Numéro de dépôt: 17783928.9
(22) Date de dépôt: 21.09.2017
(51) Int. Cl.: H01L 21/20

(54) **STRUCTURE COMPRENANT DES ILOTS SEMI-CONDUCTEURS MONOCRISTALLINS, PROCEDE DE FABRICATION D'UNE TELLE STRUCTURE**
STRUKTUR MIT EINZELKRISTALLHALBLEITERINSELN UND VERFAHREN ZUR HERSTELLUNG SOLCH EINER STRUKTUR
STRUCTURE COMPRISING SINGLE-CRYSTAL SEMICONDUCTOR ISLANDS AND PROCESS FOR MAKING SUCH A STRUCTURE

(30) Priorité: 29.09.2016 FR 1659343
(43) Date de publication de la demande: 07.08.2019
(73) Titulaire: Soitec, 38190 Bernin (FR)
(72) Inventeur: SOTTA, David, 38100 Grenoble (FR); KONONCHUK, Oleg, 38570 Theys (FR); BETHOUX, Jean-Marc, 38500 La Buisse (FR)
(74) Mandataire: IP Trust
(86) Numéro de dépôt international: PCT/FR2017/052529
(87) Numéro de publication internationale: WO 2018/060570

(56) Documents cités:
- US-A1- 2004 029 365
- US-A1- 2007 217 460
- US-A1- 2012 108 019
- US-A1- 2012 119 218
- US-A1- 2015 155 331
- US-A1- 2016 141 451
- YONGJIN WANG ET AL: "TECHNICAL NOTE; Freestanding GaN slab fabricated on patterned silicon on an insulator substrate", JOURNAL OF MICROMECHANICS & MICROENGINEERING, INSTITUTE OF PHYSICS PUBLISHING, BRISTOL, GB, vol. 20, no. 2, 1 February 2010 (2010-02-01), page 27001, XP020175327, ISSN: 0960-1317

## Description

### DOMAINE DE L'INVENTION

La présente invention concerne une structure comprenant des îlots semi-conducteurs monocristallins disposés sur un support. La structure est destinée à recevoir une couche active en matériaux III-V ou un empilement de telles couches actives, constitutive(s) d'un dispositif semi-conducteur, tel qu'une diode électroluminescente.

### ARRIERE PLAN TECHNOLOGIQUE DE L'INVENTION

Les documents « Buckling suppression of SiGe islands on compliant substrates », Yin et al (2003), Journal of Applied Physics, 94(10), 6875-6882, EP2151852 et EP2151856 divulguent différents procédés de réalisation d'un substrat formé d'un support présentant une face principale, d'une couche de diélectrique disposée sur la face principale du support, et d'une pluralité d'îlots semi-conducteurs monocristallins disposée sur la couche diélectrique.

Comme cela est exposé dans ces documents, les îlots de semi-conducteurs monocristallins sont formés dans un film continu de matériaux pour libérer la contrainte originellement présente dans ce film, par déformation au cours d'un traitement de relaxation. On forme de la sorte des îlots relaxés, ou partiellement relaxés, sans déformations excessives par gauchissement (« buckling » selon l'expression anglo-saxonne usuellement employée), dans la mesure où les îlots présentent des dimensions suffisamment petites.

La formation des îlots et le traitement de relaxation peuvent être réalisés alors que le film continu est disposé sur la couche diélectrique et le support du substrat. Alternativement, la formation des îlots et le traitement de relaxation peuvent être réalisés alors que le film continu réside sur un support intermédiaire, à partir duquel les ilots relaxés ou partiellement relaxés seront transférés sur la couche diélectrique recouvrant le support et ainsi former le substrat.

Les îlots sont avantageusement constitués de germanium, de SiGe, d'un matériau III-N de formule générale InAlGaN ou de tout autre matériau qui n'existe pas de manière courante sous forme massive.

Quelle que soit la méthode employée pour réaliser le substrat, les îlots peuvent être destinés à recevoir une couche active en matériaux III-V, ou un empilement de telles couches, semi conductrice(s) et cristalline(s) constitutive d'un dispositif semi-conducteur. Il peut s'agir par exemple de couches actives monocristallines constituant les puits quantiques d'une diode électroluminescente, ou les couches photo génératrices d'une cellule photovoltaïque. On pourra se référer à ce propos au document US2015155331.

L'élaboration de dispositifs semi-conducteurs fonctionnels et efficaces requiert de contrôler avec une très grande précision la nature et l'épaisseur des couches actives qui les constituent. Celles-ci peuvent typiquement présenter des épaisseurs comprises entre quelques nm et quelques centaines de nm.

À cet effet, on contrôle avec une très grande précision les paramètres de l'équipement de croissance (comme par exemple l'uniformité des flux de précurseur, la température et la pression partielle régnant dans la chambre de dépôt) affectant la constitution et l'uniformité des couches actives.

Malgré tout le soin apporté à contrôler ces paramètres, la demanderesse a observé qu'une couche active en matériau III-V formée sur les îlots d'un substrat « à îlot » pouvait présenter une épaisseur non uniforme, supérieure sur les bords des îlots qu'en leurs centres. C'est notamment le cas lors de la croissance d'une couche active d'InGaN sur des îlots d'InGaN relaxés ou partiellement relaxés. Cette zone périphérique en surépaisseur ne peut être exploitée, ce qui limite la surface utile des îlots.

On notera que les dimensions des îlots ne peuvent pas toujours être librement choisies pour compenser cette zone périphérique inexploitable. En effet, ces dimensions peuvent être imposées pour permettre la relaxation des îlots sans gauchissement excessif. La surface utile de l'îlot est donc nécessairement limitée, ce qui ne permet pas de former des composants semi-conducteurs de grandes dimensions et ce qui limite l'intérêt de ces substrats.

### OBJET DE L'INVENTION

La présente invention vise à pallier tout ou partie des inconvénients précités. Elle vise notamment à fournir un substrat « à îlots » pour l'élaboration d'au moins une couche active d'épaisseur uniforme.

### BREVE DESCRIPTION DE L'INVENTION

En vue de la réalisation de l'un de ces buts, l'objet de l'invention propose une structure pour l'élaboration d'au moins une couche active en matériau III-V comprenant un substrat formé d'un support présentant une face principale, d'une couche diélectrique disposée sur la face principale du support, et d'une pluralité d'îlots semi-conducteurs monocristallins disposée directement sur la couche diélectrique, les ilots présentant une surface supérieure pour servir de germe à la croissance de la couche active. Selon l'invention, la structure comprend une couche d'accroche ayant une surface en AlN polycristallin disposée entre les îlots semi-conducteurs monocristallins, directement sur la portion de la couche de diélectrique qui n'est pas recouverte par les îlots, sans masquer la surface supérieure des îlots, de sorte que la couche diélectrique ne soit plus exposée à son environnement.

La structure conforme à l'invention est destinée à recevoir, par croissance, au moins une couche active. Après avoir mené des expérimentations poussées, la demanderesse a observé que certaines espèces constitutives de la couche active, notamment lorsque celle-ci était en matériau III-V, pouvaient manquer d'affinité chimique avec le diélectrique de la couche diélectrique et ne pouvaient donc s'y fixer. Ces espèces sont alors susceptibles de migrer, pendant la croissance de la couche active, pour se fixer sur le bord des îlots, ce qui vient perturber l'uniformité d'épaisseur de la couche active qui se forme sur les îlots.

En munissant la structure d'une couche d'accroche directement sur la couche diélectrique entre les îlots semi-conducteurs, la structure de l'invention permet de prévenir ce phénomène et de former une couche active particulièrement uniforme.

Selon d'autres caractéristiques avantageuses et non limitatives de l'invention, prises seules ou selon toute combinaison techniquement réalisable :
- le support est en silicium ou en saphir ;
- la couche diélectrique comprend de l'oxyde de silicium et/ou du nitrure de silicium ;
- les îlots semi-conducteurs monocristallins comprennent un matériau III-V, et plus particulièrement un matériau III-N ;
- les îlots semi-conducteurs monocristallins sont constitués ou comprennent de l'InGaN ;
- la couche d'accroche est en AlN polycristallin.

L'invention propose également un procédé de réalisation d'une structure, le procédé comprenant la fourniture d'un substrat formé d'un support présentant une face principale, d'une couche diélectrique disposée sur toute la face principale du support, et d'une pluralité d'îlots semi-conducteurs monocristallins disposée directement sur la couche diélectrique, les îlots présentant une surface supérieure pour servir de germe à la croissance d'une couche active en matériau III-V. Selon l'invention, le procédé comprend la formation d'une couche d'accroche ayant une surface en AlN polycristallin sur la portion de couche de diélectrique qui n'est pas recouverte par les îlots, sans masquer la surface supérieure des îlots, de sorte que la couche diélectrique ne soit plus exposée à son environnement .

Selon d'autres caractéristiques avantageuses et non limitatives de l'invention, prises seules ou selon toute combinaison techniquement réalisable :
- la formation de la couche d'accroche comprend le dépôt de la couche d'accroche sur et entre les îlots semi-conducteurs monocristallins, puis le retrait sélectif de la portion de la couche d'accroche disposée sur les îlots semi-conducteurs cristallins ;
- le retrait sélectif de la portion la couche d'accroche disposée sur les îlots semi-conducteurs monocristallins est réalisé par polissage mécanochimique ;
- la formation de la couche d'accroche comprend la formation sélective d'une couche de protection sur les îlots semi-conducteurs monocristallins, le dépôt de la couche d'accroche sur la couche de protection et sur la surface exposée de la couche diélectrique entre les îlots semi-conducteurs monocristallins, et le retrait sélectif de la couche de protection et de la portion de la couche d'accroche disposée sur les îlots semi-conducteurs monocristallins ;
- la couche de protection comprend une résine photosensible et la formation sélective de la couche de protection comprend une étape de photolithographie ;
- le retrait sélectif de la couche de protection et de la couche d'accroche disposée sur la couche de protection est réalisé par gravure chimique.

L'invention concerne aussi un procédé de réalisation d'un dispositif semi-conducteur comprenant la fourniture d'une structure conforme à l'invention et la formation d'au moins une couche active en matériau III-V sur les îlots de semi-conducteurs monocristallins.

### BREVE DESCRIPTION DES DESSINS

D'autres caractéristiques et avantages de l'invention ressortiront de la description détaillée de l'invention qui va suivre en référence aux figures annexées sur lesquelles :
- Les figures 1a et 1b représentent schématiquement une vue en coupe et de dessus d'une structure conforme à l'invention ;
- La figure 2 représente un procédé de réalisation d'un dispositif semi-conducteur à l'aide d'une structure conforme à l'invention ;
- La figure 3 représente les étapes d'un procédé de réalisation d'une structure conforme à l'invention selon un premier mode de réalisation ;
- La figure 4 représente les étapes d'un procédé de réalisation d'une structure conforme à l'invention selon un deuxième mode de réalisation.

### DESCRIPTION DETAILLEE DE L'INVENTION

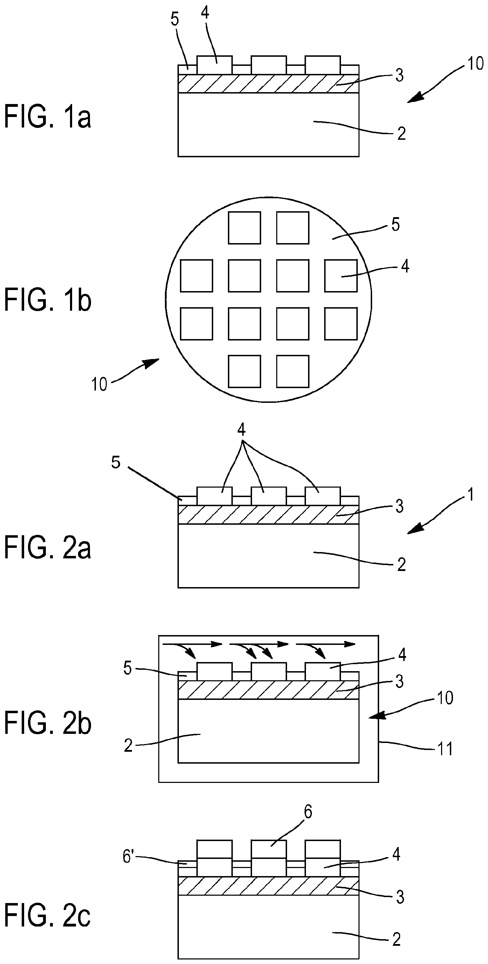

Les figures 1a et 1b représentent schématiquement une vue en coupe et de dessus d'une structure 10 conforme à l'invention. La structure 10 peut avoir la forme d'une plaquette, circulaire, de dimension normalisée, par exemple de 2 pouces (50 mm), 4 pouces (100 mm) voire 200 mm de diamètre. Mais l'invention n'est nullement limitée à ces dimensions ou à cette forme.

La structure 10 comprend un support 2, par exemple en silicium ou en saphir. Le support 2 présente une face principale. Une couche diélectrique 3 est disposée sur la surface principale du support 2. La couche diélectrique 3 peut être constituée de dioxyde de silicium, de nitrure de silicium, ou d'un empilement simple ou multiple de couches constituées par exemple de ces matériaux. La couche diélectrique 3 peut présenter une épaisseur comprise entre 10 nm et plusieurs microns.

La structure 10 comprend également, directement sur la couche diélectrique 3, une pluralité d'îlots semi-conducteurs monocristallins 4 (plus simplement désignés « îlots » dans la suite de la description). Par « pluralité d'îlots » on désigne un film formé d'un ensemble de zones indépendantes et non jointives, ces zones pouvant être délimitées par des tranchées exposant la couche diélectrique 3 comme cela est apparent sur la figure 1b. Les îlots peuvent tous présenter des tailles et/ou des formes identiques ou différentes entre elles.

L'invention n'est nullement limitée à des îlots 4 d'une nature particulière, mais la structure 10 trouve une application particulièrement intéressante lorsque ces îlots sont constitués d'un matériau III-V, notamment de l'InGaN, relaxé ou partiellement relaxé. Le matériau InGaN peut comporter une proportion d'indium compris entre 1% et 10%. Chaque îlot peut présenter une épaisseur comprise entre 100 nm et 200nm, et présenter une dimension principale (diamètre ou longueur selon la forme de l'îlot) comprise entre quelques microns et 1 mm. Les îlots 4 peuvent être séparés les uns des autres par des tranchées dont la largeur peut être comprise entre 1 et 50 microns, et conduisant à exposer la couche diélectrique à son environnement.

On peut de la sorte former une structure 10 présentant des îlots 4 dont les surfaces exposées présentent un paramètre de maille compris entre 0,3189 nm et 0,3210 nm, apte à recevoir au moins une couche active en matériau III-V pour constituer un dispositif semi-conducteur tel qu'une diode électroluminescente.

On pourrait également choisir de former, suivant la nature du dispositif semi-conducteur qui est réalisé, la pluralité d'îlots en AlGaN, ou en tout autre matériau, tel qu'un matériau III-V, et plus particulièrement un matériau III-N.

Selon l'invention, la structure 10 comprend également entre les îlots 4, directement sur la couche diélectrique 3, une couche d'accroche 5. Cette couche d'accroche 5 est disposée directement sur la portion de la couche diélectrique 3 qui n'est pas recouverte par les îlots 4, de sorte que cette couche diélectrique 3 ne soit plus exposée directement à son environnement. La couche d'accroche 5 ne masque pas la surface supérieure des îlots 4 afin que ces surfaces puissent servir de germe à la croissance de la couche active (ou de l'empilement de couches actives). La nature de la couche d'accroche 5 est choisie pour présenter une affinité chimique suffisante avec tous les éléments constitutifs de la couche active qui sera formée sur la structure 10. La couche d'accroche 5 est donc apte à fixer ces éléments et prévenir leurs migrations au cours de la formation d'une couche active. En d'autres termes, la couche d'accroche (5), de par sa nature et sa disposition, permet de limiter le transport de matière, typiquement la diffusion d'adatomes, de la surface de la couche d'accroche (5) vers la surface des ilots (4) ou de la couche active (6) qui est formée sur ces îlots.

La structure 10, et notamment les îlots 4, est destinée à recevoir une couche active comprenant un matériau III-V , la couche accroche 5 est en AlN. Elle est formée par dépôt directement sur la couche diélectrique 3 et la couche d'accroche 5 est polycristalline.

En effet, il a été observé par la demanderesse au cours de ses expérimentations poussées que certains éléments de la colonne III et de la colonne V (et notamment l'indium) étaient particulièrement peu réactifs avec le diélectrique de la couche diélectrique 3 et ne pouvaient donc s'y fixer. Ils peuvent par contre se fixer tous aisément sur une couche d'accroche 5 en AlN.

L'épaisseur de la couche d'accroche 5 n'est pas particulièrement déterminante, car seule la nature de sa surface exposée est exploitée dans le cadre de la présente invention. A ce titre, la couche d'accroche peut être composée d'une pluratité de couches empilées les unes sur les autres, et seule la couche dont la surface exposée à l'environnement nécessite de présenter une affinité chimique avec les éléments constitutifs de la couche active. Pratiquement, cette épaisseur sera suffisante pour recouvrir parfaitement la couche diélectrique 3 entre les îlots 4, tout en restant d'une épaisseur inférieure ou égale à celle des îlots 4 afin de maintenir saillantes leurs surfaces exposées et favoriser la formation ultérieure de la couche active. À titre d'exemple, la couche d'accroche 5 peut présenter une épaisseur comprise entre quelques nm et quelques centaines de nm.

La figure 2 représente un procédé de réalisation d'un dispositif semi-conducteur tirant profit de la structure 10 qui vient d'être décrite.

Au cours d'une première étape représentée sur la figure 2a, on fournit une structure 10 conforme à l'invention. La structure 10 peut être disposée dans la chambre 11 d'un équipement conventionnel de croissance. Comme cela est bien connu en soi, la chambre est parcourue par des flux de gaz précurseurs, transportant les espèces constitutives de la couche active, et portée en température. Comme cela est représenté schématiquement à la figure 2b, les espèces comprises dans les gaz précurseurs circulant dans la chambre 11, réagissent avec les surfaces exposées de la structure 10. Sur les surfaces exposées des îlots 4 de semi-conducteurs monocristallin, une couche active monocristalline 6 se forme progressivement par épitaxie. La bonne affinité chimique entre la couche d'accroche 5 et toutes les espèces constitutives de la couche active 6 conduit également à la formation d'une couche 6' entre les îlots 4, sur la couche d'accroche 5. On évite ainsi que certaines espèces ne migrent et ne se déposent sur les bords de la surface exposée des îlots comme cela est le cas en l'absence de la couche d'accroche 5.

A l'issue de cette étape, et comme cela est représenté sur la figure 2c, on dispose d'une structure 10 présentant à la surface des îlots 4 une couche active semi conductrice et monocristalline 6, dont l'épaisseur est uniforme. Par exemple, une couche active 6 peut présenter une uniformité similaire à celle de l'îlots sur laquelle elle a été formée.

Entre les îlots 4, sur la couche d'accroche 5, une couche de résidus 6' qui peut être polycristalline, s'est constituée. Cette couche de résidus 6' n'est pas particulièrement utile et peut-être éliminée, par des étapes conventionnelles de masquage de la couche utile 6 par une résine photosensible, insolation photo-lithographique, et gravure sèche ou humide de la couche 6'.

La (ou les couches actives) 6 disposée sur la structure 10 peuvent subir des traitements complémentaires, bien connus en soi, tels que la formation de couches additionnelles, la formation de contacts électriques, le transfert sur un substrat final de sorte à compléter la réalisation du dispositif semi-conducteur et le rendre fonctionnel.

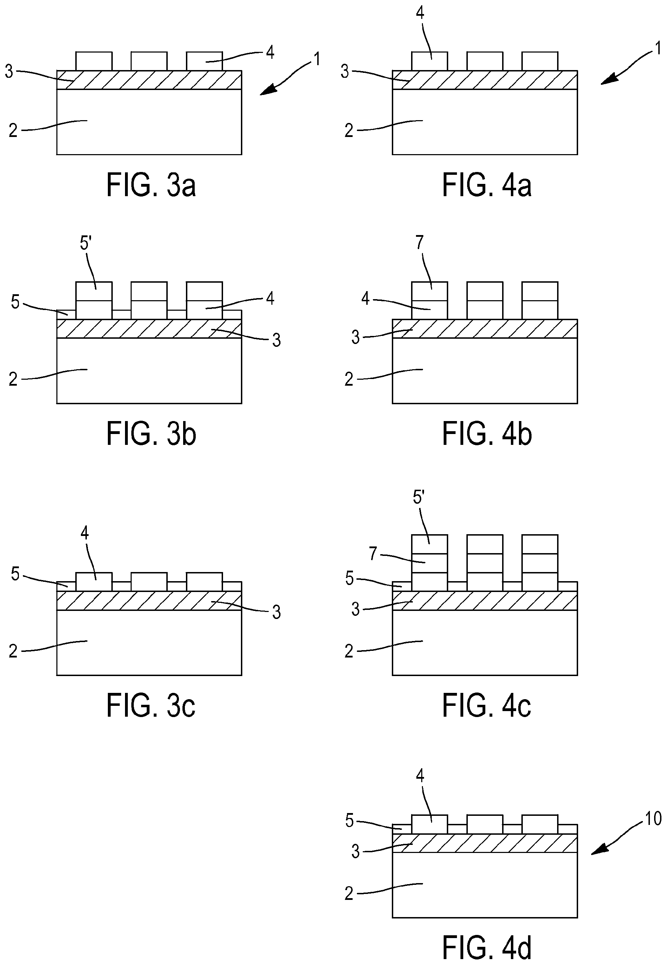

La figure 3 représente les étapes de réalisation d'une structure 10 conforme à l'invention selon un premier mode de réalisation.

Dans une première étape représentée sur la figure 3a, on fournit un substrat 1 comprenant un support 2, qui présente une face principale, une couche diélectrique 3 sur toute la face principale du support 2 et une pluralité d'îlots 4 semi-conducteurs cristallins disposée directement sur la couche diélectrique 3.

La manière particulière avec laquelle ce substrat 1 a été obtenu n'est pas particulièrement pertinente dans le cadre de la présente invention, et on pourra choisir par exemple l'une des méthodes présentées dans l'exposé de l'état de la technique.

Dans une deuxième étape 3b, on forme une couche d'accroche 5, 5' sur l'ensemble de la surface exposée du substrat 1. Une portion de la couche d'accroche 5' est disposée sur les îlots 4, et une portion complémentaire de la couche d'accroche 5 est disposée entre les îlots 4, directement sur la couche diélectrique 3.

Au cours d'une troisième étape, on procède au retrait de la portion de la couche d'accroche 5' disposés sur les îlots 4 de manière à exposer leur surface, en vue du dépôt ultérieur d'une couche active 6 ou d'une pluralité de telles couches.

Cette étape de retrait peut être réalisée de multiples manières.

Selon une première approche, on soumet le substrat de la figure 3b à une étape de polissage mécanochimique (CMP de l'acronyme anglo-saxon « Chemical Mechanical Polishing ») de manière à sélectivement éliminer par amincissement mécanique et chimique la portion de la couche d'accroche 5' disposée sur les îlots 4 de la surface du substrat.

Selon une autre approche, on élimine par gravure sèche ou humide la portion 5' de la couche d'accroche disposée sur les îlots 4 après avoir préalablement et sélectivement masqué à l'aide d'une couche de protection la portion de la couche d'accroche 5 disposée directement la couche diélectrique 3. Ce masquage sélectif peut être réalisé par les étapes traditionnelles de dépôt pleine surface d'une résine, de l'insolation de cette résine à travers un masque photo lithographique définissant les zones de la résine à éliminer, et le retrait chimique de la résine dans ces zones.

À l'issue de cette étape, on dispose comme cela est représenté sur la figure 3c, d'une structure 10 conforme à l'invention comportant une couche d'accroche 5 uniquement disposée entre les îlots 4, directement sur la couche diélectrique 3.

La figure 4 représente les étapes de réalisation d'une structure 10 conforme à l'invention selon un deuxième mode de réalisation.

La première étape représentée sur la figure 4a de fourniture du substrat 1 est identique à celle du premier mode de réalisation et les mêmes commentaires s'y appliquent.

Dans une deuxième étape, représentée sur la figure 4b, on masque sélectivement à l'aide d'une couche de protection 7, par exemple une couche de résine, la surface exposée des îlots 4.

Cette étape de masquage sélectif peut être réalisée par un procédé traditionnel de dépôt pleine surface de la résine, son insolation à travers un masque photo lithographique permettant de définir des zones correspondant aux îlots 4 où la résine doit être préservée, et le retrait chimique sélectif de la résine en dehors de ces zones.

Dans une troisième étape représentée sur la figure 4c, on forme la couche d'accroche 5, 5' sur l'ensemble de la surface exposée du substrat 1. Une portion de la couche d'accroche 5' réside sur la couche de protection 7 masquant les îlots 4, et une autre portion de la couche d'accroche 5 est disposée quant à elle directement sur la couche diélectrique 5, entre les îlots 4.

Au cours d'une quatrième étape, on procède au retrait de la couche de protection 7 et de la portion de la couche d'accroche 5' qui réside sur la couche de protection 7. Cela peut être obtenu par exemple en dispensant une solution chimique de gravure permettant de sélectivement éliminer la couche de protection 7 et conduisant à l'élimination de la portion de la couche d'accroche 5'. À l'issue de cette étape, on dispose donc, comme représenté sur la figure 4d, d'une structure 10 conforme à l'invention.

Bien entendu, l'invention n'est pas limitée à l'exemple décrit et on peut y apporter des variantes de réalisation sans pour autant sortir du cadre de l'invention, tel que celui-ci est défini par les revendications qui suivent.

Ainsi, par « semi-conducteur monocristallin » on désigne un matériau semi-conducteur sous forme cristalline, dans lequel la maille du cristal est continue, c'est-à-dire qu'elle ne présente pas de joint de grains. Le cristal peut toutefois présenter des défauts, ou imperfections tels que des défauts ponctuels, des dislocations, sans perdre son caractère monocristallin.

La structure 10, outre le substrat 2, la couche diélectrique 3, les îlots 4 et la couche d'accroche 5, peut comporter d'autres couches, par exemple disposée sous la couche diélectrique 3.

Par ailleurs, il n'est pas nécessaire que la couche diélectrique 3 recouvre toute la surface principale du support 2. Elle peut par exemple être disposée uniquement sur le support 2, entre les îlots 4, voire même sur une partie seulement de la surface du support 2 compris entre les îlots 4. Dans tous les cas, et conformément à l'invention, la couche d'accroche 5 est formée au moins directement sur la couche diélectrique 3 susceptible d'être exposée à son environnement.

## Revendications

1. Structure (10) pour l'élaboration d'au moins une couche active en matériau III-V (6) comprenant un substrat formé d'un support (2) présentant une face principale, d'une couche diélectrique (3) disposée sur la face principale du support, et d'une pluralité d'îlots semi-conducteurs monocristallins (4) disposée directement sur la couche diélectrique (3), les îlots présentant une surface supérieure pour servir de germe à la croissance de la couche active, la structure étant **caractérisée en ce qu'**elle comprend une couche d'accroche ayant une surface en AlN polycristallin (5) disposée entre les îlots semi-conducteurs monocristallins (4), directement sur la portion de la couche diélectrique (3) qui n'est pas recouverte par les îlots (4), sans masquer la surface supérieure des îlots (4), de sorte que la couche diélectrique (3) ne soit plus exposée à son environnement.

2. Structures (10) selon la revendication précédente dans lequel le support (2) est en silicium ou en saphir.

3. Structure (10) selon l'une des revendications précédentes dans lequel la couche diélectrique (3) comprend de l'oxyde de silicium et/ou du nitrure de silicium.

4. Structure (10) selon l'une des revendications précédentes dans laquelle les îlots semi-conducteurs monocristallins (4) comprennent un matériau III-V.

5. Structure (10) selon la revendication précédente dans laquelle les îlots semi-conducteurs monocristallins (4) sont constitués ou comprennent de l'InGaN.

6. Procédé de réalisation d'une structure (10) comprenant la fourniture d'un substrat (1) formé d'un support (2) présentant une face principale, d'une couche diélectrique (3) disposée sur la face principale du support (2), et d'une pluralité d'îlots semi-conducteurs monocristallins (4) disposée directement sur la couche diélectrique (3), les îlots présentant une surface supérieure pour servir de germe à la croissance d'une couche active en matériau III-V, le procédé étant **caractérisé en ce qu'**il comprend la formation d'une couche d'accroche ayant une surface en AlN polycristallin (3), entre les îlots semi-conducteurs monocristallins (4), directement sur la portion de couche de diélectrique (2) qui n'est pas recouverte par les îlots (4), sans masquer la surface supérieure des îlots (4), de sorte que la couche diélectrique (3) ne soit plus exposée à son environnement.

7. Procédé selon la revendication précédente dans lequel la formation de la couche d'accroche (5) comprend le dépôt de la couche d'accroche (5, 5') sur et entre les îlots semi-conducteurs monocristallins (4), puis le retrait sélectif de la portion de la couche d'accroche (5') disposée sur les îlots semi-conducteurs cristallins (4).

8. Procédé selon la revendication précédente dans lequel le retrait sélectif de la portion la couche d'accroche (5') disposée sur les îlots semi-conducteurs monocristallins (4) est réalisé par polissage mécanochimique.

9. Procédé selon la revendication 6 dans lequel la formation de la couche d'accroche (5) comprend la formation sélective d'une couche de protection (7) sur les îlots semi-conducteurs monocristallins (4), le dépôt de la couche d'accroche (5, 5') sur la couche de protection et sur la surface exposée de la couche diélectrique (3) entre les îlots semi-conducteurs monocristallins (4), et le retrait sélectif de la couche de protection (7) et de la portion de la couche d'accroche (5') disposée sur les îlots semi-conducteurs monocristallins (4).

10. Procédé sur la revendication précédente dans lequel la couche de protection (7) comprend une résine photosensible et la formation sélective de la couche de protection (7) comprend une étape de photolithographie.

11. Procédé selon l'une des deux revendications précédentes dans lequel le retrait sélectif de la couche de protection (7) et de la couche d'accroche (5') disposée sur la couche de protection (7) est réalisé par gravure chimique.

12. Procédé de réalisation d'un dispositif semi-conducteur comprenant la fourniture d'une structure (10) selon l'une de revendications 1 à 5 et la formation d'au moins une couche active en matériau III-V sur les îlots de semi-conducteurs monocristallins (4).

## Patentansprüche

1. Struktur (10) zur Herstellung mindestens einer aktiven Schicht (6) aus III-V-Material, umfassend ein Substrat, das aus einem Träger (2) mit einer Hauptfläche, einer dielektrischen Schicht (3), die auf der Hauptfläche des Trägers angeordnet ist, und mehreren monokristallinen Halbleiterinseln (4) gebildet ist, die direkt auf der dielektrischen Schicht (3) angeordnet sind, wobei die Inseln eine obere Oberfläche aufweisen, die als Keim für das Wachstum der aktiven Schicht dient, wobei die Struktur **dadurch gekennzeichnet ist, dass** sie eine Verbindungsschicht mit einer polykristallinen AIN-Oberfläche (5) umfasst, die zwischen den monokristallinen Halbleiterinseln (4) direkt auf dem Abschnitt der dielektrischen Schicht (3) angeordnet ist, der nicht von den Inseln (4) bedeckt ist, ohne die obere Oberfläche der Inseln (4) zu maskieren, so dass die dielektrische Schicht (3) nicht mehr ihrer Umgebung ausgesetzt ist.

2. Strukturen (10) nach dem vorhergehenden Anspruch, wobei der Träger (2) aus Silizium oder Saphir besteht.

3. Struktur (10) nach einem der vorhergehenden Ansprüche, wobei die dielektrische Schicht (3) Siliziumoxid und/oder Siliziumnitrid umfasst.

4. Struktur (10) nach einem der vorhergehenden Ansprüche, wobei die monokristallinen Halbleiterinseln (4) ein III-V-Material umfassen.

5. Struktur (10) nach dem vorhergehenden Anspruch, wobei die monokristallinen Halbleiterinseln (4) aus InGaN hergestellt sind oder InGaN umfassen.

6. Verfahren zur Herstellung einer Struktur (10), umfassend das Bereitstellen eines Substrats (1), das aus einem Träger (2) mit einer Hauptfläche, einer dielektrischen Schicht (3), die auf der Hauptfläche des Trägers (2) angeordnet ist, und mehreren monokristallinen Halbleiterinseln (4) gebildet ist, die direkt auf der dielektrischen Schicht (3) angeordnet sind, wobei die Inseln eine obere Oberfläche aufweisen, die als Keim für das Wachstum einer aktiven Schicht aus III-V-Material dient, wobei das Verfahren **dadurch gekennzeichnet ist, dass** es das Bilden einer Verbindungsschicht mit einer polykristallinen AlN-Oberfläche (3) zwischen den monokristallinen Halbleiterinseln (4) direkt auf dem Abschnitt der dielektrischen Schicht (2) umfasst, der nicht von den Inseln (4) bedeckt ist, ohne die obere Oberfläche der Inseln (4) zu maskieren, so dass die dielektrische Schicht (3) nicht mehr ihrer Umgebung ausgesetzt ist.

7. Verfahren nach dem vorhergehenden Anspruch, wobei das Bilden der Haftschicht (5) das Abscheiden der Haftschicht (5, 5') auf und zwischen monokristallinen Halbleiterinseln (4) und anschließend das selektive Entfernen des Abschnitts der Haftschicht (5') umfasst, der auf den kristallinen Halbleiterinseln (4) angeordnet ist.

8. Verfahren nach dem vorhergehenden Anspruch, wobei das selektive Entfernen des auf den monokristallinen Halbleiterinseln (4) angeordneten Abschnitts der Haftschicht (5') durch mechanochemisches Polieren erfolgt.

9. Verfahren nach Anspruch 6, wobei das Bilden der Haftschicht (5) das selektive Bilden einer Schutzschicht (7) auf den monokristallinen Halbleiterinseln (4) und das Abscheiden der Haftschicht (5, 5') auf der Schutzschicht und auf der freiliegenden Oberfläche der dielektrischen Schicht (3) zwischen den monokristallinen Halbleiterinseln (4), und das selektive Entfernen der Schutzschicht (7) und des Abschnitts der Haftschicht (5') umfasst, der auf den monokristallinen Halbleiterinseln (4) angeordnet ist.

10. Verfahren nach dem vorhergehenden Anspruch, wobei die Schutzschicht (7) ein lichtempfindliches Harz umfasst und wobei das selektive Bilden der Schutzschicht (7) einen Photolithographieschritt umfasst.

11. Verfahren nach einem der beiden vorhergehenden Ansprüche, wobei das selektive Entfernen der Schutzschicht (7) und der auf der Schutzschicht (7) angeordneten Haftschicht (5') durch chemisches Ätzen erfolgt.

12. Verfahren zur Herstellung einer Halbleitervorrichtung, umfassend das Bereitstellen einer Struktur (10) nach einem der Ansprüche 1 bis 5 und das Bilden mindestens einer aktiven Schicht aus III-V-Material auf den monokristallinen Halbleiterinseln (4).

## Claims

1. Structure (10) for developing at least one active layer of III-V material (6), comprising a substrate which is formed by a support (2) having a main face, by a dielectric layer (3) arranged on the main face of the support, and by a plurality of monocrystalline semiconductor islands (4) arranged directly on the dielectric layer (3), the islands having an upper surface to be used as a seed for the growth of the active layer, the structure being **characterized in that** it comprises a bonding layer having a polycrystalline AIN surface (5) arranged between the monocrystalline semiconductor islands (4), directly on the portion of the dielectric layer (3) which is not covered by the islands (4), without masking the upper surface of the islands (4), such that the dielectric layer (3) is no longer exposed to its environment.

2. Structures (10) according to the preceding claim, wherein the support (2) is made of silicon or sapphire.

3. Structure (10) according to either of the preceding claims, wherein the dielectric layer (3) comprises silicon oxide and/or silicon nitride.

4. Structure (10) according to any of the preceding claims, wherein the monocrystalline semiconductor islands (4) comprise a III-V material.

5. Structure (10) according to the preceding claim, wherein the monocrystalline semiconductor islands (4) consist of or comprise InGaN.

6. Method for producing a structure (10), comprising providing a substrate (1) which is formed by a support (2) having a main face, by a dielectric layer (3) arranged on the main face of the support (2), and by a plurality of monocrystalline semiconductor islands (4) arranged directly on the dielectric layer (3), the islands having an upper surface to be used as a seed for the growth of an active layer of III-V material, the method being **characterized in that** it comprises forming a bonding layer having a polycrystalline AIN surface (3), between the monocrystalline semiconductor islands (4), directly on the portion of the dielectric layer (2) which is not covered by the islands (4), without masking the upper surface of the islands (4), such that the dielectric layer (3) is no longer exposed to its environment.

7. Method according to the preceding claim, wherein the formation of the bonding layer (5) comprises depositing the bonding layer (5, 5') on and between the monocrystalline semiconductor islands (4), followed by selectively removing the portion of the bonding layer (5') arranged on the crystalline semiconductor islands (4).

8. Method according to the preceding claim, wherein the selective removal of the portion the bonding layer (5') arranged on the monocrystalline semiconductor islands (4) is achieved by mechanochemical polishing.

9. Method according to claim 6, wherein the formation of the bonding layer (5) comprises selectively forming a protective layer (7) on the monocrystalline semiconductor islands (4), depositing the bonding layer (5, 5') on the protective layer and on the exposed surface of the dielectric layer (3) between the monocrystalline semiconductor islands (4), and selectively removing the protective layer (7) and the portion of the bonding layer (5') arranged on the monocrystalline semiconductor islands (4).

10. Method according to the preceding claim, wherein the protective layer (7) comprises a photosensitive resin and the selective formation of the protective layer (7) comprises a photolithography step.

11. Method according to either of the two preceding claims, wherein the selective removal of the protective layer (7) and of the bonding layer (5') arranged on the protective layer (7) is achieved by chemical etching.

12. Method for producing a semiconductor device, comprising providing a structure (10) according to any of claims 1 to 5 and forming at least one active layer of III-V material on the monocrystalline semiconductor islands (4).
